# EUROPEAN PATENT APPLICATION

(11) **EP 2 648 491 A2**
(43) Date of publication of application: **09.10.2013**
(21) Application number: 13162244.1
(22) Date of filing: 04.04.2013
(51) Int. Cl.: H05K 1/14

(54) **A circuit board system**

(30) Priority: 05.04.2012 FI 20125389
(71) Applicant: Tellabs Oy, 02630 Espoo (FI)
(72) Inventor: Holma, Antti, FI-02920 Espoo (FI); Laihonen, Jari-Pekka, FI-02730 Espoo (FI)
(74) Representative: Berggren Oy Ab

(57) **Abstract**

A circuit board system comprises a first circuit board (201) furnished with SMD components (202) and conductive patterns (203). There are one or more surface-mounted support elements (206) on the first circuit board. Each of them comprises an electrically conductive bottom surface (207) soldered to a respective conductive pattern (203) of the first circuit board (201). A second circuit board (208) is mechanically connected to the one or more support elements (206). At least one electronic component (209) is mounted to the second circuit board (208) and electrically coupled to at least one conductive pattern (203) of the first circuit board (201) through at least one of said support elements (206).

## Description

### Field of the invention

The invention relates generally to circuit board systems where two or more circuit boards are rigidly connected together. More particularly, the invention relates to a mechanical structure that enables designing said circuit boards in an advantageous way concerning component distribution, and conductor location as well as repair and maintenance operations.

### Background

The two most commonly encountered principal solutions for connecting electronic components to circuit boards are through-hole mounting and surface mounting. Through-hole mounting involves passing a conductor wire of the component through a hole in the circuit board and soldering it to a conductive pad that surrounds or touches the hole on the other side, while surface mounting involves soldering a flat connection surface of the component to a conductive pad on the same side of the circuit board on which the component is located. The acronyms THT (through-hole technology) and SMD (surface-mounted device) are frequently used.

Different soldering techniques are used for THT and SMD solutions. For THT, so-called wave soldering is commonly used, where the circuit board with premounted components is supported over a bath of flowing solder. SMD technology typically calls for reflow soldering, where a sticky paste of solder and flux is used to preliminarily attach the components in place and subsequently melted with a heat treatment.

From the viewpoint of process automation, SMD technology (often combined with the use of press-fit components) is more advantageous, because it is more easily automatized and requires less post-processing for example in the form of solder checking. However, some - particularly high-power - components are not available in SMD or press-fit form. This may lead to the use of mixed technologies, where a circuit board comprises both SMD and THT components and consequently must undergo two different kinds of soldering.

The use of tightly packed, double-sided circuit boards causes problems in the wave soldering used for THT components. Heat-sensitive areas on the side to be soldered must be protected, which may leave the open areas so small that getting a sufficient amount of heat conducted to the circuit board becomes difficult. If the circuit board comprises thick and broad copper areas, which may be needed for meeting EMI standards and/or power handling capacity requirements, the copper may conduct and spread heat so efficiently that no sufficient amounts of thermal energy can be concentrated to the locations where soldering should take place.

Another drawback of tightly packed circuit boards is the difficulty of making maintenance operations that may require replacing failed components. Some component types, like overvoltage protectors, are intentionally designed as the breaking points of the circuit: the first failure that exceptional conditions cause will occur in a controlled manner and in a component where the failure is easy to find. Detaching a soldered joint is possible, but it involves the risk of causing damage to nearby components on the circuit board.

A prior art document DE 10 2007 035 794 A1 suggests a structure of the kind shown in fig. 1. THT components 101 are placed on a separate "daughter" board 102, the edges of which comprise extending conductor wires 103 arranged in lines. An insulating spacer bar 104 extending across an edge of the daughter board has holes, through which the conductor wires 103 pass before being bent to a 90 degrees angle. The bent ends of the conductor wires 103 are soldered to conductive pads on the surface of a "mother" board 105, which only comprises SMD components.

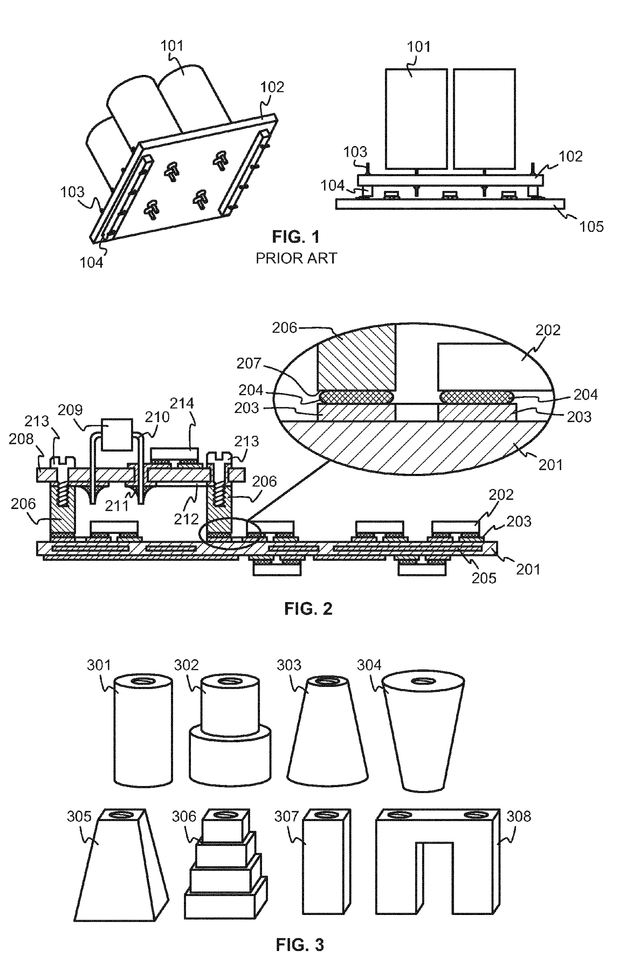

The structure shown in fig. 1 has a number of drawbacks. For example, the placing, bending, and soldering of the conductor wires 103 is not easily automatized, and the connector structures that are constituted by the conductor wires 103 and the spacer bars 104 reserve a considerable amount of space from the mother board 105. Each conductor wire 103 may be required to carry a considerable amount of electric power, which places strict requirements to the thickness and soldering of the conductor wires. It is possible that in order to bring the high-power tracks on the mother board 105 to the appropriate locations, they need to be drawn through routes that are not optimal with reference to sensitive signal lines that may appear on the same circuit board.

### Summary

The following presents a simplified summary in order to provide a basic understanding of some aspects of various invention embodiments. The summary is not an extensive overview of the invention. It is neither intended to identify key or critical elements of the invention nor to delineate the scope of the invention. The following summary merely presents some concepts of the invention in a simplified form as a prelude to a more detailed description of exemplifying embodiments of the invention.

In accordance with a first aspect of the invention, there is provided a circuit board system that comprises:
- a first circuit board furnished with surface-mounted electronic components and comprising conductive patterns,
- one or more surface-mounted support elements on the first circuit board, each of said one or more support elements comprising an electrically conductive bottom surface soldered to a respective conductive pattern of the first circuit board,
- a second circuit board mechanically connected to the one or more support elements,
- at least one electronic component mounted to the second circuit board and electrically coupled to at least one conductive pattern of the first circuit board through at least one of said support elements, and
- at least one electronic component is through-hole-mounted to the second circuit board.

When a support element that mechanically connects the two circuit boards together simultaneously implements an electrical coupling, the surface area that needs to be reserved from the circuit boards is only of the size of that surface of the support element that comes against the circuit board. Using SMD technology to attach the support element to the first circuit board enables assembling the whole first circuit board in a SMD process. The support elements can be placed relatively freely, allowing great flexibility and possibilities for optimization in circuit board design, and the mechanical connection between the support elements and the second circuit board enables easy servicing.

In accordance with a second aspect of the invention, there is provided a method for assembling a circuit board system. The method comprises:
- furnishing a first circuit board with surface-mounted electronic components,
- soldering one or more surface-mounted support elements by their electrically conductive bottom surfaces to respective conductive patterns of the first circuit board,
- furnishing a second circuit board with at least one electronic component,
- mechanically connecting the second circuit board to said one or more support elements so that at least one of said electronic components on the second circuit board becomes electrically coupled to at least one conductive pattern of the first circuit board through at least one of said support elements, and
- furnishing said second circuit board with components comprises through-hole mounting at least one electronic component to the second circuit board.

A number of non-limiting exemplifying embodiments of the invention are described in accompanied dependent claims.

Various non-limiting exemplifying embodiments of the invention both as to constructions and to methods of operation, together with additional objects and advantages thereof, will be best understood from the following description of specific exemplifying embodiments when read in connection with the accompanying drawings.

The verb "to comprise" is used in this document as an open limitation that neither excludes nor requires the existence of unrecited features. The features recited in depending claims are mutually freely combinable unless otherwise explicitly stated.

### Brief description of the figures

The exemplifying embodiments of the invention and their advantages are explained in greater detail below in the sense of examples and with reference to the accompanying drawings, in which:
- fig. 1: illustrates a prior art solution,
- fig. 2: illustrates a circuit board system,
- fig. 3: illustrates a number of alternative forms of support elements,
- fig. 4: illustrates a number of alternative ways of making a mechanical connection,
- fig. 5: illustrates a number of alternative cross-sections of support elements, and
- fig. 6: illustrates a method.

### Description of the exemplifying embodiments

Fig. 2 is a partial cross section of a circuit board system, which comprises a first circuit board 201 furnished with surface-mounted electronic components 202. The designation "SMD components" is used here for short. The first circuit board 201 comprises conductive patters 203, which include the contact pads to which the SMD components are connected with solder 204. The dimensions in the drawing are not to scale, and especially the thickness of the solder 204 has been exaggerated in order to make it more clearly perceivable. It is possible but not necessary that the first circuit board 201 is a multilayer circuit board, in which case it comprises also internal conductive patterns 205 inside the circuit board material. It is similarly possible but not necessary that the first circuit board comprises SMD components on its both sides.

In addition to the SMD components, there are one or more surface-mounted support elements 206 on the first circuit board. Each of said support elements 206 comprises an electrically conductive bottom surface 207, which is soldered to a respective conductive pattern 203 of the first circuit board 201. The solder 204 establishes an electrically conductive connection between the bottom surface 207 of the support element and the conductive pattern 203, which further establishes an electrically conductive connection to or from other parts of the first circuit board. The conductive pattern 203, to which the support element 206 is soldered by its bottom surface, may be a dedicated contact pad on the surface of the first circuit board 201, in which case it is typically matched in form and size to the bottom surface 207 of the support element 206. However, the conductive pattern to which the support element is soldered may also be smaller than the bottom surface 207 (for example a conductive track that runs under the bottom surface 207) or it may be larger than the bottom surface (for example a conductive area that simultaneously establishes a ground plane or an EMI shielding layer, or otherwise extends across a larger area of the first circuit board 201).

A second circuit board 208 is mechanically connected to the one or more support elements 206. In the embodiment of fig. 2 the mechanical connection of the second circuit board 208 to each surface-mounted support element comprises a screw 213 extending through a hole in the second circuit board 208 to a threaded hole in a top surface of the respective support element 206 that faces the second circuit board 208. Later in this description we will consider alternative ways for making the mechanical connection.

At least one electronic component is mounted to the second circuit board 208 and electrically coupled to at least one conductive pattern of the first circuit board 201 through at least one of said support elements 206. In fig. 2 a through-hole mounted component 209 is shown, so that the electric coupling from the through-hole mounted electronic component 209 goes via the connection wire 210 - which is part of the component 209 - through a THT solder joint 211 to a conductive pattern 212 that in the mechanical connection is squeezed against the electrically conductive top surface of the respective support element 206, from which there is further an electrically conductive connection through the electrically conductive body of the support element 206 to its bottom surface. In this description, directional expressions like "top" and "bottom" are used only to facilitate easier comparison to the drawings and they do not limit the applicability of features of the invention in any way.

In the embodiment of fig. 2 the THT component 209 is on the top side of the second circuit board 208, i.e. on that side that faces out of the first circuit board 201. Since it is characteristic to THT soldering that the solder joints and the conductive patterns are on the other side of the circuit board than the components, this placing of the component 209 has the natural consequence that the solder joint 211 and the conductive pattern 212 face the first circuit board 201, and an electrically conductive connection between the conductive pattern 212 and the support element 206 can be made in the way described above. If the whole second circuit board 208 would be turned upside down in comparison to its position in fig. 2, a corresponding electrically conductive connection could be made by allowing the conductive pattern 212 continue under the head of the screw 213 and by using the body of the screw as a part of the electrically conductive connection. The second circuit board 208 may comprise THT components and conductive patterns on its both sides.

The holes in the second circuit board 208 may be through-plated, as is shown at the right end of the THT component 209 and at the rightmost screw in fig. 2. However, this is not a requirement of the invention; corresponding connections with no through-plated holes are shown at the left end of the THT component 209 and at the leftmost screw in fig. 2. Through-plated holes make it particularly easy to attach components to the second circuit board, because the components may come on each side of the second circuit board, with the through-plated holes acting as vias that provide the necessary electrical connections between the sides.

The components mounted on the second circuit board 208 are not necessarily THT components, or not necessarily all THT components. An SMD component 214 is shown as an example on the second circuit board 208 of fig. 2. Although dedicating the second circuit board to THT components produces the advantage of only having to take each circuit board to one soldering process, certain advantages can be achieved even if the second circuit board comprises SMD components. The components on the second circuit board may include overvoltage protectors or other such components that are the intentionally designed breaking points of the circuit, and need to be investigated and/or replaced in the course of maintenance and repair. Placing them on a separate circuit board, which additionally may be detached and re-attached with a simple, detachable mechanical connection that simultaneously implements the electric coupling, allows for example replacing the whole second circuit board quickly and easily.

It should be noted that the invention does not require even the first circuit board 201 to be furnished exclusively with SMD components, although such an embodiment allows taking full advantage of the avoidance of different soldering methods for an individual circuit board. For example, if the invention is only utilized to place the most typically failing components on a separate circuit board for easy replacing, the first circuit board may well comprise also THT and other kinds of components.

Fig. 3 illustrates some examples of forms that a support element may have. The support elements 301 and 302 consist of a cylindrical (in the case of 301 a simple cylindrical, in the case of 302 a double cylindrical) body, a limiting surface (end surface) of which is transversal to the longitudinal axis of the cylindrical form and constitutes the (conductive) bottom surface that comes against and is soldered SMD-wise to a conductive pattern of a first circuit board. The support elements 303 and 304 consist of a conical body, a limiting (end) surface is the conductive bottom surface. Simultaneously the support elements 303 and 304 illustrate the fact that if a support element according to any embodiment of the invention has a cross section that changes along its longitudinal direction (which is the direction transverse to the plane defined by the first circuit board), the change can be in any direction.

The support elements 305 and 306 consist of a pyramidal body, a limiting (end) surface of which is the conductive bottom surface. Simultaneously the support elements 305 and 306 illustrate the fact that if a support element according to any embodiment of the invention has a cross section that changes along its longitudinal direction (which is the direction transverse to the plane defined by the first circuit board), the change can take place continuously (as in 305) or stepwise (as in 306). The support element 307 consists of a prismatic body, a limiting (end) surface of which is the conductive bottom surface. Although a prismatic form is actually just a special case of a cylinder (which in mathematics is defined as the surface drawn by a straight line that moves, without changing its direction, along a closed path), the prismatic form 307 is shown here separately for the avoidance of doubt.

The support element 308 illustrates the fact that a support element according to an embodiment of the invention may comprise a first number of limiting surfaces against the first circuit board, and a second number, different than said first number, of limiting surfaces against the second circuit board. In this example, the support element 308 has a branching body, and two separate (although parallel) limiting surfaces that will come against the first circuit board. Only one limiting surface will come against the second circuit board. The branching of the body of the support element could be also in the other direction, for example so that it had one limiting surface against the first circuit board and two limiting surfaces against the second circuit board.

Different forms of support elements can be used together in one and the same circuit board system.

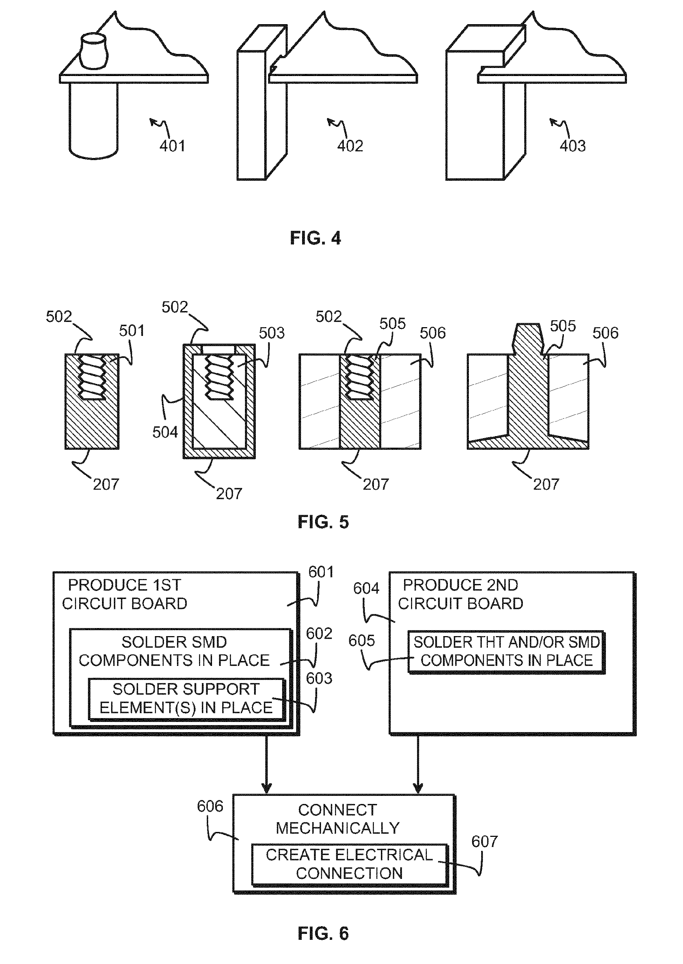

In each of the cases illustrated in figs. 2 and 3, the surface-mounted support elements define a threaded hole in a surface facing the second circuit board. Consequently, the mechanical connection of the second circuit board to the surface-mounted support elements should comprise a screw extending through the second circuit board to said threaded hole. Fig. 4 illustrates some alternative forms of a mechanical connection, where the mechanical connection between a second circuit board and a surface-mounted support element comprises a projection in one and a slot in the other.

In case 401, the projection is a pin extending from a top surface of the support element in the direction of its longitudinal axis, and the slot is a hole in the second circuit board. In order to ensure better mechanical attachment, the pin may comprise a slightly thicker middle portion or other formations, past which the circuit board must be forced. Case 401 also shows, how implementing the electrically conductive coupling between the second circuit board and the support element does not necessarily need to involve directly making a conductive pattern on one of the planar surfaces of the circuit board touch a top surface of the support element: if the hole in the second circuit board is a so-called plated-through hole, the electrically conductive coupling may take place between the plated inner walls of the hole and the side surfaces of the pin.

In case 402, the projection is a tab in the edge of the second circuit board, and the slot is a corresponding recess in the support element. In case 403, the projection is actually just one part of the straight edge of the second circuit board, and the slot is a groove in the support element. Threadless mechanical connections, for example like those illustrated in fig. 4, can be used together with threaded mechanical connections like those illustrated in fig. 2, so that the second circuit board is slid or pushed in place to some of the support elements and the connection is secured with a screw in one or more further support elements.

The leftmost part of fig. 5 illustrates a support element that consists of an electrically conductive body 501, a limiting surface of which is said conductive bottom surface 207. The opposite limiting surface of the conductive body 501 is the conductive top surface 502 that can be used for implementing the electrically conductive coupling between the second circuit board and the support element. This kind of support elements were also illustrated in fig. 2.

Next from left in fig. 5 is a support element that comprises a body 503 made of electrically insulating material, said body having mutually parallel top and bottom surfaces. There are electrically conductive coatings on the top and bottom surfaces of the insulating body 503. The conductive coating on the bottom surface constitutes the electrically conductive bottom surface 207, and the conductive coating on the top surface constitutes an electrically conductive top surface 501. An electrical conductor connects the electrically conductive coatings on the top and bottom surfaces of the body together. In the embodiment of fig. 5 the electrical conductor consists of a coating 504 that covers all side surfaces of the insulating body 503. As an alternative, there could be e.g. only a stripe (or a number of stripes) of electrically conductive coating running along a side of the insulating body 503 and connecting the electrically conductive top and bottom coatings to each other.

Another example illustrated in fig. 5 comprises an electrically conductive core 505, a limiting surface of which at the bottom constitutes the electrically conductive bottom surface 207. A top surface 502 of the core 505 is available for making an electrically conductive connection to the second circuit board, but an electrically conductive screw wound through a hole in the second circuit board to the threaded hole defined by the core 505 could also be used. An electrically insulating casing 506 surrounds the electrically conductive core 505 on its sides.

The rightmost alternative illustrated in fig. 5 is a reminder that an electrically conductive part of the support element does not need to have a constant cross section along the longitudinal (vertical) axis of the support element. Similarly to the previous one, the rightmost alternative also comprises an electrically conductive core 505 surrounded on its sides by an electrically insulating casing 506. In order to maximize the strength of the solder joint to the first circuit board, the bottom surface 207 of the electrically conductive core 505 is larger than the cross-section of the electrically conductive core 505 higher up. A pin-type formation is shown as a reminder that a threaded hole and a screw are not the only ways of making a mechanical connection.

Fig. 6 illustrates a method for assembling a circuit board system. Step 601 represents furnishing a first circuit board with surface-mounted electronic components. As a part thereof, the SMD components are soldered in place as illustrated in step 602. Support elements have been placed on the first circuit board preferably by the same pick-and-place machine that also places other SMD components, and provided with solder paste, so support elements are most advantageously soldered by their electrically conductive bottom surfaces to the respective conductive patterns of the first circuit board in the same soldering step in which the other surface-mounted electronic components are soldered in place on the first circuit board. This is illustrated as step 603 in fig. 6.

It is advantageous to form the support elements so that they are easily adaptable for picking and placing by a mechanical arm of an assembling machine. The top of the support element, which ultimately is to be mechanically connected to the second circuit board, most preferably exhibits a solid, flat horizontal surface (for a suction picker), a pin (for a pincer picker), a slot (for a needle picker) or other formation that allows the mechanical arm to grab the support element and to move and press it in place on the first circuit board.

Step 604 represents furnishing a second circuit board with at least one electronic component, which may be a THT or SMD component. As the attaching substep, soldering the THT and/or SMD component(s) in place is shown with reference designator 605. In some cases the attachment step of through-hole mounting can made with a nut wound to threads on the pin that comes through the circuit board. Attaching an SMD component may comprise the use of electrically conductive glue, so the attachment step is not necessarily always a soldering step.

Step 606 represents mechanically connecting the second circuit board to the one or more support elements that were previously attached to the first circuit board. Making the mechanical connection also causes at least one of the electronic components on the second circuit board to become electrically coupled to at least one conductive pattern of the first circuit board through at least one of the support elements, which is separately shown as step 607.

Embodiments of the invention allow placing a number of THT components on a separate circuit board, and avoiding the combination of reflow soldering and wave soldering in the manufacturing process of an individual circuit board. The soldering process for the THT components can be optimized without having to take heat protection or conductive heat loss into account, as would be the case if the THT components were placed on a tightly-packed circuit board, possibly including large copper areas, together with the SMD components. Utilizing the body of a support element (or a coating, a core, or other significant part of the body) as an electrical conductor allows conducting even relatively large currents between the circuit boards safely and with little additional resistance. Making the electrical connection from the first circuit board to the support element does not necessarily reserve any more than the bottom area of the support element, which saves space on the first circuit board. From the viewpoint of circuit board design, support elements according to embodiments of the invention can be made spot-like, so they can be placed relatively freely at arbitrary locations of the first (and second) circuit board where they and the conductive patterns to which they are coupled cause minimal nuisance to designing the other parts of the circuit board.

## Claims

1. A circuit board system comprising:
- a first circuit board (201) furnished with surface-mounted electronic components (202) and comprising conductive patterns (203),
- one or more surface-mounted support elements (206) on the first circuit board, each of said one or more support elements comprising an electrically conductive bottom surface (207) soldered to a respective conductive pattern of the first circuit board,
- a second circuit board (208) mechanically connected to the one or more support elements (206),
- at least one electronic component (209) mounted to the second circuit board (208) and electrically coupled to at least one conductive pattern (203) of the first circuit board (201) through at least one of said support elements (206), and
- at least one electronic component (209) is through-hole-mounted to the second circuit board (208).

2. A circuit board system according to claim 1, wherein each of said surface-mounted support elements (206) consists of a cylindrical (301, 302), conical (303, 304), pyramidal (305, 306), or prismatic (307) body, a limiting surface of which is said conductive bottom surface (207).

3. A circuit board system according to claim 1, wherein at least one of said surface-mounted support elements comprises:
- a first number of limiting surfaces against the first circuit board, and
- a second number, different than said first number, of limiting surfaces against the second circuit board.

4. A circuit board system according to any of claims 1-3, wherein:
- at least one of said surface-mounted support elements defines a threaded hole in a surface facing said second circuit board, and
- the mechanical connection of the second circuit board to said at least one of said surface-mounted support elements comprises a screw (213) extending through the second circuit board (208) to said threaded hole.

5. A circuit board system according to any of claims 1-3, wherein the mechanical connection of the second circuit board to at least one of said surface-mounted support elements comprises a projection in one and a slot in the other.

6. A circuit board system according to any of claims 1-5, wherein at least one of said surface-mounted support elements consists of an electrically conductive body (501), a limiting surface of which is said conductive bottom surface (207).

7. A circuit board system according to any of claims 1-5, wherein at least one of said surface-mounted support element comprises:
- a body (503) made of electrically insulating material, said body having mutually parallel top and bottom surfaces,
- electrically conductive coatings on the top and bottom surfaces of said body, of which the conductive coating on the bottom surface constitutes the electrically conductive bottom surface (207), and
- an electrical conductor (504) connecting the electrically conductive coatings on the top and bottom surfaces of the body.

8. A circuit board system according to any of claims 1-5, wherein at least one of said surface-mounted support element comprises:
- an electrically conductive core (505), a limiting surface of which constitutes the electrically conductive bottom surface (207), and
- an electrically insulating casing (506) surrounding said electrically conductive core (505).

9. A method for assembling a circuit board system, the method comprising:
- furnishing (601) a first circuit board with surface-mounted electronic components,
- soldering (603) one or more surface-mounted support elements by their electrically conductive bottom surfaces to respective conductive patterns of the first circuit board,
- furnishing (604) a second circuit board with at least one electronic component,
- mechanically connecting (606) the second circuit board to said one or more support elements so that at least one of said electronic components on the second circuit board becomes electrically coupled (607) to at least one conductive pattern of the first circuit board through at least one of said support elements, and
- furnishing (604) said second circuit board with components comprises through-hole mounting at least one electronic component to the second circuit board.

10. A method according to claim 9, wherein said one or more surface-mounted support elements are soldered (603) by their electrically conductive bottom surfaces to respective conductive patterns of the first circuit board in a soldering step (602) in which also said surface-mounted electronic components are soldered in place on the first circuit board.
